# EUROPÄISCHE PATENTSCHRIFT

(11) **EP 0 915 535 B1**
(45) Veröffentlichungstag und Bekanntmachung des Hinweises auf die Patenterteilung: **13.04.2005**
(21) Anmeldenummer: 98120820.0
(22) Anmeldetag: 03.11.1998
(51) Int. Cl.: H01R 13/658

(54) **Störstrahlsicheres Steckverbindergehäuse und dessen Kabelöffnung verschliessendes Einsatzstück**
EMI proof connector housing and closing element for the cable openings
Boîtier de connecteur blindé contre les interférences électromagnétiques et éléments de fermeture des arrivées de câble

(30) Priorität: 09.11.1997 DE 29719842 U
(43) Veröffentlichungstag der Anmeldung: 12.05.1999
(73) Patentinhaber: Schmitt, Fred, 74388 Talheim (DE)
(72) Erfinder: Schmitt, Fred, 74388 Talheim (DE)
(74) Vertreter: Müller, Hans, Dipl.-Ing.

(56) Entgegenhaltungen:
- FR-A- 2 744 851
- US-A- 4 722 580
- US-A- 4 761 145

## Beschreibung

### TECHNISCHES GEBIET

Die Erfindung betrifft ein störstrahlsicheres Gehäuse, das zur Aufnahme mindestens eines Steckverbinders und mindestens eines in das Gehäuse hineingeführten und mit dem Steckverbinder verbundenen elektrischen Kabels dient. Die Steckverbinder, die an oder in dem Gehäuse befestigt werden können, entsprechen beispielsweise der Norm IEC-625 oder IEEE-488. Die Gehäuse weisen ferner eine oder mehrere Öffnungen auf, durch die je nach Anschlußrichtung aus verschiedenen Richtungen das jeweilige elektrische Kabel mittels eines Einsatzstückes in das Gehäuse eingeführt werden kann. Die Einsatzstücke besitzen dann eine zentrale Durchtrittsöffnung für das elektrische Kabel. Sofern kein Kabel durch die Gehäuseöffnung führen soll, wird die Öffnung durch ein eine geschlossene Gehäusewand bildendes andersartiges Einsatzstück verschlossen. Die Erfindung betrifft auch ein derartiges Einsatzstück.

### STAND DER TECHNIK

Bekannte störstrahlsichere Gehäuse besitzen ein wannenartiges Bodenteil, bei dem eine Gehäusewand fehlt. Das Bodenteil wird durch ein Deckelteil, das größenmäßig in etwa dem Boden des Bodenteils entspricht, verschlossen. In der fehlenden Gehäusewand, die eine Stirnfläche des Gehäuses bildet, kann ein Steckverbinder eingesetzt werden. An anderen Stirnflächen des Gehäuses sind Öffnungen in der Gehäusewand vorgesehen zum Einführen von elektrischen Kabeln. Diese vorbereiteten Öffnungen können einerseits von einem Blindstopfen und andererseits von einem eine zentrale Durchtrittsöffnung aufweisenden Crimpflansch verschlossen werden. Der Crimpflansch besteht dabei aus einer eine Öffnung aufweisenden Schiebeplatte, in der eine Hülse zug-, druckfest und verdrehsicher eingesetzt ist. Blindstopfen und Crimpflansch stellen jeweils ein Einsatzstück dar, das bei entferntem Deckelteil aus Richtung des Deckels in die Öffnung eingesetzt, das heißt in die Gehäusewand eingeschoben werden kann. Das Einsatzstück stößt dann einerseits auf dem Boden des Bodenteils auf und berührt andererseits den auf das Bodenteil aufgeschraubten Deckel. In den sich gegenüberliegenden Seitenwänden des Einsatzstückes ist jeweils ein schulterartiger Vorsprung vorhanden, der mit jeweils einem entsprechenden Rücksprung in der benachbarten Wand des Bodenteils korrespondiert. Somit weist die Berührfläche zwischen dem Einsatzstück und der Wand eine Stufe auf. Dadurch soll der Berührkontakt zwischen Einsatzstück und Gehäuse sichergestellt werden, um den elektrischen Widerstand zwischen Einsatzstück und Gehäuse zu verkleinern und dadurch einen verbesserten HF-Übergang zwischen Einsatzstück und Gehäuse zu ermöglichen.

Ein ähnliches, gattungsgemäßes störstrahlsicheres Gehäuse ist aus der US-A-4,761,145 bekannt. Die dafür vorgesehenen, als Blindstopfen oder Crimpflansch ausgebildeten Einsatzstücke besitzen an ihrer jeweiligen Seitenfläche eine im Querschnitt rechteckförmige Längsrippe.

### DARSTELLUNG DER ERFINDUNG

Ausgehend von diesem vorbekannten Stand der Technik liegt der Erfindung die Aufgabe zugrunde, ein störstrahlsicheres Gehäuse mit passendem Einsatzstück anzugeben, bei dem der elektrische Widerstand zwischen dem Gehäuse und dem Einsatz stück möglichst gering ist.

Diese Erfindung ist für das erfindungsgemäße Gehäuse durch die Merkmale des Patentanspruchs 1 gegeben. Ausgehend von dem im Stand der Technik bekannten störstrahlsicheren Gehäuse zur Aufnahme eines Steckverbinders mit einem mit ihm verbundenen elektrischen Kabel zeichnet sich das erfindungsgemäße Gehäuse durch eine mehrstufige innige Verzahnung zwischen der Gehäusewand und dem Einsatzstück aus. Die Berührungsfläche im Bereich der Verzahnung zwischen Einsatzstück und Gehäusewand ist länger als es beim Stand der Technik der Fall ist. Die gegenüber dem Stand der Technik vergrößerte Berührungsfläche bewirkt einen verkleinerten elektrischen Widerstand und damit einen verbesserten HF-Übergang zwischen Einsatzstück und Gehäusewand. Die zumindest doppelt vorhandene mäanderförmige Berührungsfläche stellt auch einen verbesserten Spritzwasserschutz im Bereich zwischen dem Einsatzstück und der Gehäusewand dar. Das dem erfindungsgemäßen Gehäuse angepaßte erfindungsgemäße Einsatzstück ist Gegenstand des Anspruchs 8.

Um die Gefahr des Entstehens von Luftspalten zwischen Einsatzstück und Gehäusewand noch zu vermindern, können auf den Seitenflächen des Vorsprunges vom Einsatzstück Längsrippen oder auch nur mehr punktuelle Auswölbungen vorgesehen sein. Die Längsrippen oder Auswölbungen können sich beim Einsetzen des Einsatzstückes in das Gehäuse pressend an dem Gehäuse anlegen oder sich zumindest teilweise auch in das Gehäuse eingraben. Störende Luftspalte zwischen Gehäuse und Einsatzstück sind dadurch praktisch nicht vorhanden.

Ausführungen für verschiedene Verzahnungen sind Gegenstand von Unteransprüchen und darüber hinaus in verschiedenen Ausführungsformen zeichnerisch dargestellt.

Auf der dem Boden- und dem Deckelteil zugewandten Außenfläche des Einsatzstückes können ein stiftartiger oder rippenartiger Vorsprung auskragend vorhanden sein. Damit wird auf einfache Weise eine besonders dichte beziehungsweise pressende Anlage des Einsatzstückes auch an dem Boden und an dem Deckelteil sichergestellt.

Weitere Ausgestaltungen und Vorteile der Erfindung sind den in den Ansprüchen weiterhin aufgeführten Merkmalen sowie den nachfolgenden Ausführungsbeispielen zu entnehmen.

### KURZE BESCHREIBUNG DER ZEICHNUNG

Die Erfindung wird im folgenden anhand der in der Zeichnung dargestellten Ausführungsbeispiele näher beschrieben und erläutert. Es zeigen:
- Fig. 1: eine Draufsicht eines Gehäusebodenteils nach der Erfindung in einer ersten Ausführungsform,
- Fig. 2: eine vergleichbare Draufsicht eines im Stand der Technik bekannten Gehäuses,
- Fig. 3: ein Einsatzstück in Form eines Crimpflansches, passend zu dem Gehäuse nach Fig. 1,
- Fig. 4: ein Einsatzstück in Form eines Blindstopfens, passend zu dem Gehäuse nach Fig. 1,
- Fig. 5: eine ausschnittsweise Darstellung einer zweiten Ausführungsform eines Gehäuses nach der Erfindung,
- Fig. 6: eine Darstellung entsprechend Fig. 3 mit einem in das Gehäuse nach Fig. 5 passenden Einsatzstück,
- Fig. 7: eine ausschnittsweise Darstellung einer dritten Ausführungsform eines Gehäuses nach der Erfindung,
- Fig. 8: eine Darstellung entsprechend Fig. 3 mit einem in das Gehäuse nach Fig. 7 passenden Einsatzstück,
- Fig. 9: eine ausschnittsweise Darstellung einer vierten Ausführungsform eines Gehäuses nach der Erfindung,
- Fig. 10: eine Darstellung entsprechend Fig. 3 mit einem in das Gehäuse nach Fig. 9 passenden Einsatzstück,
- Fig. 11: eine ausschnittsweise Darstellung einer fünften Ausführungsform eines Gehäuses nach der Erfindung,
- Fig. 12: eine Darstellung entsprechend Fig. 3 mit einem in das Gehäuse nach Fig. 11 passenden Einsatzstück,
- Fig. 13: eine ausschnittsweise Darstellung einer sechsten Ausführungsform eines Gehäuses nach der Erfindung,
- Fig. 14: eine Darstellung entsprechend Fig. 3 mit einem in das Gehäuse nach Fig. 13 passenden Einsatzstück,
- Fig. 15: eine ausschnittsweise Darstellung einer siebten Ausführungsform eines Gehäuses nach der Erfindung,
- Fig. 16: eine Darstellung entsprechend Fig. 3 mit einem in das Gehäuse nach Fig. 15 passenden Einsatzstück,
- Fig. 17: eine ausschnittsweise Darstellung einer achten Ausführungsform eines Gehäuses nach der Erfindung,
- Fig. 18: eine Darstellung entsprechend Fig. 3 mit einem in das Gehäuse nach Fig. 17 passenden Einsatzstück,
- Fig. 19: eine ausschnittsweise Darstellung einer neunten Ausführungsform eines Gehäuses nach der Erfindung,
- Fig. 20: eine Darstellung entsprechend Fig. 3 mit einem in das Gehäuse nach Fig. 19 passenden Einsatzstück.

### WEGE ZUM AUSFÜHREN DER ERFINDUNG

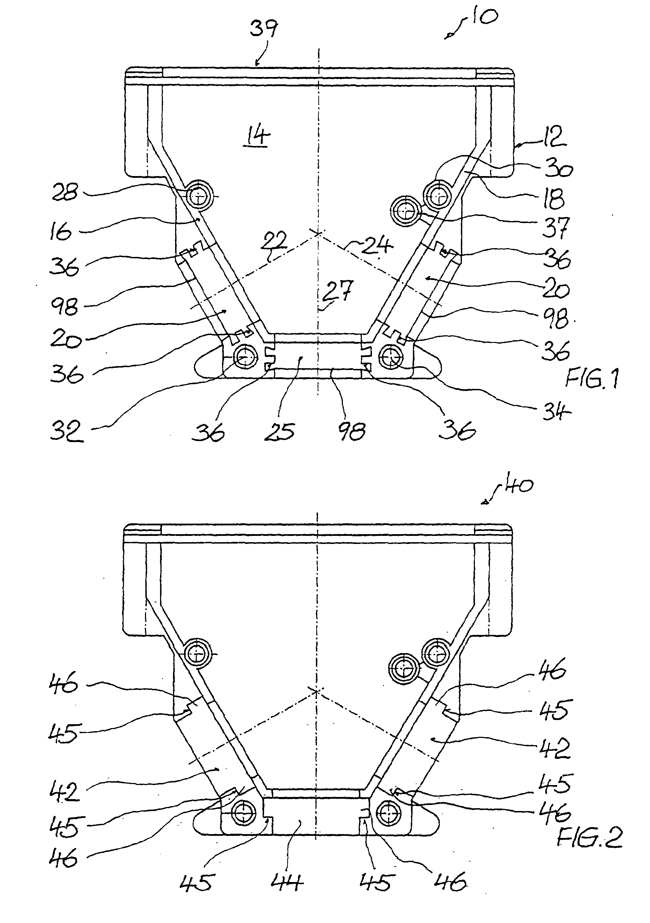

Ein störstrahlsicheres Gehäuse 10 besitzt ein Bodenteil 12 (Fig.1). Das Bodenteil 12 wird durch ein nicht näher dargestelltes Deckelteil von - bezüglich der Zeichenebene - oben verschlossen. Das Bodenteil 12 besitzt einen flachen Boden 14, der von gegenüberliegenden Seitenwänden 16, 18 eingerahmt wird. In den beiden Seitenwänden sind Einsatzstücke 20 vorhanden, die eine längs einer Achse 22, 24 vorhandene Öffnung in der Seitenwand 16, 18 verschließen. Diese beiden Einsatzstücke 20 sind sogenannte Blindstopfen, wie noch nachstehend näher beschrieben wird.

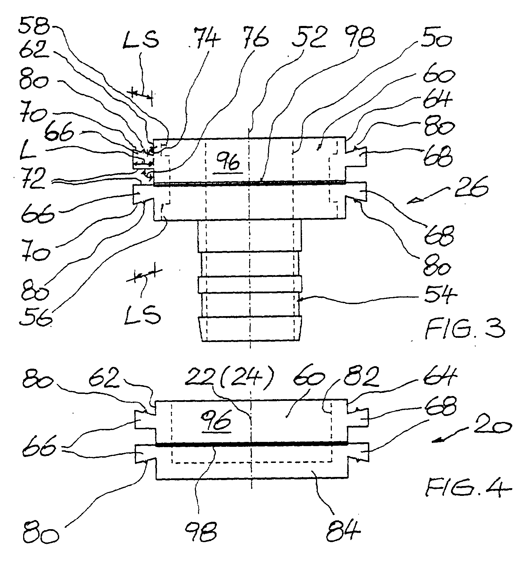

Im in der Zeichnung (Fig. 1) unteren Ende des Gehäuses 10 kann in die dortige Gehäuseöffnung ein in Fig.3 dargestelltes weiteres Einsatzstück 26 eingesetzt werden, von dem in Fig. 1 lediglich ihre Schiebeplatte 25 angedeutet ist. Das Einsatzstück 26 ist zum Einführen eines nicht näher dargestellten elektrischen Kabels in das Innere des Gehäuses 10 vorgesehen. Die Schiebeplatte 25 besitzt eine zentrale Öffnung mit der Achse 27 als Mittelachse (Fig. 1). Die Einsatzstücke 20, 26 sind mittels einer mehrstufigen Verzahnung in der Seitenwand 16 beziehungsweise 18 eingefügt, wie ebenfalls noch näher beschrieben wird. Auf der der Schiebeplatte 25 des Einsatzstückes 26 gegenüberliegenden Gehäuseseite ist eine Öffnung 39 für einen Steckverbinder vorhanden.

In den Seitenwänden 16, 18 ist jeweils eine Wandverbreiterung 28, 30 mit einem Innengewinde zum Anschrauben des Deckelteils ausgebildet. Derartige Anschraubstellen sind auch in den zur Schiebeplatte 25 benachbarten Ecken (Innen gewinde 32, 34) vorgesehen. Das Deckelteil wird also im vor-liegenden Fall an vier Stellen mit dem Bodenteil 12 verschraubt. Von der rechten Seitenwand 18 ragt ferner eine Anschraubstelle 37 aus, über die eine Masseverbindung hergestellt werden kann.

In dem Gehäuse 10 besitzt jedes der eingesetzten Einsatzstücke 20, 26 mit der jeweils seitlich benachbarten Seitenwand 16 beziehungsweise 18 eine mehrstufige Verzahnung 36. Diese mehrstufige Verzahnung 36, die im Nachstehenden noch näher beschrieben und in unterschiedlichen Variationen dargestellt ist, stellt eine gegenüber dem Stand der Technik längere und damit großflächigere sowie eine mehr Abknickungen aufweisende Berührfläche zwischen Einsatzstück und Seitenwand dar. Der elektrische Widerstand zwischen dem Einsatzstück und der Seitenwand ist dadurch entsprechend klein. Außerdem stellt die mäanderförmige, mehrstufige Verzahnung einen verbesserten Schutz gegen eindringendes Spritzwasser dar.

Ein im Stand der Technik bekanntes Gehäuse 40 (Fig. 2) besitzt zwei als Blindstopfen ausgebildete Einsatzstücke 42 und einen Crimpflansch als Einsatzstück zum Einführen eines Kabels. Die Schiebeplatte 44 dieses Crimpflansches ist in Fig. 2 angedeutet. Diese Einsatzstücke sind mit einer einstufigen Verzahnung 45 in der Seitenwand 16 beziehungsweise 18 eingesetzt. Dadurch ist auf den gegenüberliegenden Seiten des quaderförmigen Grundkörpers jedes Einsatzstückes 42, 44 lediglich ein Vorsprung 46 ausgebildet. Bei dem erfindungsgemäßen Gehäuse 10 beziehungsweise den in dieses Gehäuse eingesetzten erfindungsgemäßen Einsatzstücken 20, 26 sind - beispielsweise gemäß Fig. 1, 3, 4 - statt dessen zwei Vorsprünge bei jeder Verzahnung 36 vorhanden.

In Fig. 3 ist das als Crimpflansch ausgebildete Einsatzstück 26 dargestellt. Es besitzt eine durchgehende Öffnung 50 mit Längsachse 52. Diese Längsachse 52 fällt mit der Längsachse eines in das Gehäuse 10 eingeführten, in der Zeichnung nicht dargestellten Kabels und mit der Achse 27 des Gehäuses 1o zusammen. In dem Einsatzstück 26 ist eine Hülse 54 eingesetzt, die mittels zweier voneinander beabstandeter umlaufender Kragen 56, 58 in Längsrichtung der Längsachse 52 zug-, druckfest und damit verschiebesicher sowie außerdem noch verdrehsicher in dem Einsatzstück einsitzt. Die Hülse 54 ist querschnittsmäßig passend zum einzuführenden Kabel ausgelegt. Der Kabelmantel liegt in zusammengebautem Zustand auf der Hülse 54 dicht an, während die Adern des Kabels durch die Hülse 54 durchgeführt werden. Auf den Kabelmantel wird eine weitere Hülse aufgeschoben und an den Mantel angequetscht. Dadurch kann der Mantel fest auf der Hülse 54 angebracht werden. Diese Befestigung eines Kabels an der Hülse 54 ist bekannt.

Das Einsatzstück 26 (Fig. 3) besitzt im vorliegenden Fall einen quaderförmigen Körper 60 mit durchgehender Öffnung 50. Von diesem Körper 60 kragen auf seinen beiden gegenüberliegenden Seitenwänden 62, 64 jeweils zwei Vorsprünge 66, 68 aus. Die beiden Seitenwände 62, 64 stoßen im eingebauten Zustand an die jeweilige Seitenwand 16 beziehungsweise 18 des Gehäuses 10 an.

In zur Längsachse 52 senkrechter Richtung kragen die beiden Vorsprünge 66, 68 um die Länge L von der Seitenwand 62 beziehungsweise 64 aus.

Jeder Vorsprung 66, 68 besitzt von der Seitenwand 62, 64 auskragende und an dem Körper beziehungsweise an dessen Seitenwänden 62, 64 anstoßende Seitenflächen 70, 72. Die eine Seitenfläche 70 ist unter einem nicht 90 Grad betragenden Winkel 74 zur Seitenwand 62, 64 ausgerichtet. Ihre von der Seitenwand 62, 64 auskragende Länge LS ist damit länger als die entsprechend auskragende Länge L der anderen Seitenfläche 72, die unter einem rechten Winkel 76 von der Seitenwand 62 beziehungsweise 64 auskragt. Die auskragende aufsummierte Länge beider Seitenflächen 70, 72 von beiden Vorsprüngen 66 (beziehungsweise 68) beträgt 2 LS + 2 L und ist damit größer als 2 L.

Auf jeder Seitenfläche 70 ist eine Längsrippe 80 ausgebildet. Beim Einsetzen des Einsatzstückes 26 in die Seitenwand 16 beziehungsweise 18 reibt die Längsrippe 80 an der Stoßfläche beziehungsweise Kontaktfläche der Seitenwand. Dadurch ist eine dichte Anlage beziehungsweise ein durchgehender Berührkontakt zwischen Einsatzstück und Seitenwand gegeben. Die Vorsprünge 66, 68 mit den Längsrippen 80 sind so ausgeformt, daß das Einsatzstück 26 mit Preßsitz von "oben" auf das vom Deckelteil befreite Bodenteil 12 eingesetzt werden kann. In der Seitenwand 16 sind entsprechende Einwölbungen und Vorsprünge, die den Vorsprüngen 66, 68 und ihrer gegenseitigen Anordnung entsprechend angepaßt sind. Das Einsatzstück 26 sitzt dann mit Preßsitz in der betreffenden Seitenwand 16, 18.

Neben dem Einsatzstück 26, das im Bereich eines in das Gehäuse 10 einzuführenden elektrischen Kabels vorgesehen ist, sind die im vorliegenden Beispiel dazu benachbarten Gehäuseöffnungen durch das Einsatzstück 20 verschlossen. Dieses Einsatzstück 20 stellt einen Blindstopfen dar, wie bereits ausgeführt ist. Das Einsatzstück 20 besitzt die gleichen Vorsprünge 66, 68 und Längsrippen 80 wie das Einsatzstück 26 und sitzt mit entsprechendem Preßsitz in den Seitenwänden 16 beziehungsweise 18. Seine Durchgangsöffnung 82 ist auf einer Seite stirnseitig durch eine Wand 84 verschlossen. Dadurch bildet das Einsatzstück 20 einen Verschluß für die betreffende Öffnung in der Seitenwand 16, 18. Die Einsatzstücke 20, 26 können wahlweise in die Öffnungen des Gehäuses eingesetzt werden.

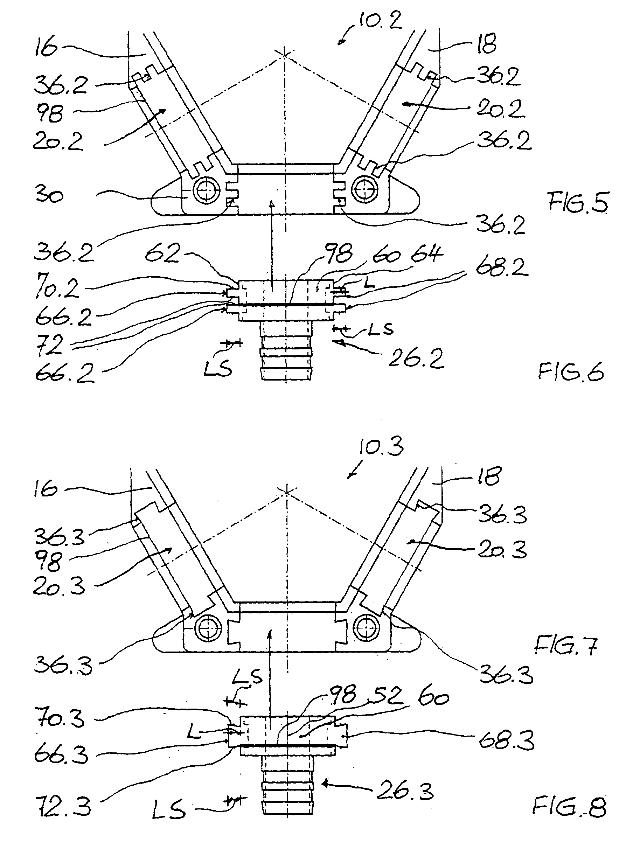

Das in Fig. 5 dargestellte Gehäuse 10.2 unterscheidet sich vom Gehäuse 10 durch eine etwas andere Verzahnung 36.2 der in dem Gehäuse 10.2 einsitzenden Einsatzstücke 20.2 beziehungsweise des in das Gehäuse 10 einsetzbaren Einsatzstückes 26.2. Auch die Verzahnung 36.2 und damit auch das Einsatzstück 26.2 besitzt jeweils zwei seitlich auskragende Vorsprünge 66.2 beziehungsweise 68.2. Im Gegensatz zum Einsatzstück 26 ist beim Einsatzstück 26.2 und damit bei der Verzahnung 36.2 die Seitenfläche 70.2 in gleicher Weise wie die jeweils gegenüberliegende Seitenfläche 72 rechtwinklig zur Seitenwand 62 beziehungsweise 64 des quaderförmigen Körpers 60 ausgerichtet. Die auskragende Länge L der beiden Vorsprünge 66.2 und 68.2 entspricht damit der Kraglänge LS jeder Seitenfläche 70.2 beziehungsweise 72. Für das Einsatzstück 26.2 und dessen Vorsprünge 66.2 beziehungsweise 68.2 beträgt die aufsummierte Kraglänge der jeweiligen beiden Vorsprünge 66.2 beziehungsweise 68.2 dem Wert 4 LS. Dieser Wert entspricht dem Wert 4 L und ist damit größer als 2 L beim Gehäuse 40.

Das in Fig. 7 dargestellte Gehäuse 10.3 entspricht den vorstehend beschriebenen Gehäusen mit dem Unterschied einer andersartigen Verzahnung 36.3 zwischen dem jeweiligen Einsatzstück 20.3, 26.3 und der betreffenden Seitenwand 16, 18. Von dem quaderförmigen Körper 60 des Einsatzstückes 26.3 kragt seitlich jeweils ein einzelner im Querschnitt schwalberischwanzförmiger Vorsprung 66.3, 68.3 aus. Dessen sich gegenüberliegenden Seitenflächen 70.3, 72.3 sind schräg zur Längsachse 52 vorhanden. Ihre Länge LS ist damit größer als die auskragende Länge L des betreffenden Vorsprungs 66.3 beziehungsweise 68.3. Es gilt für jeden Vorsprung, daß die beiden Längen LS größer sind als beide Längen L.

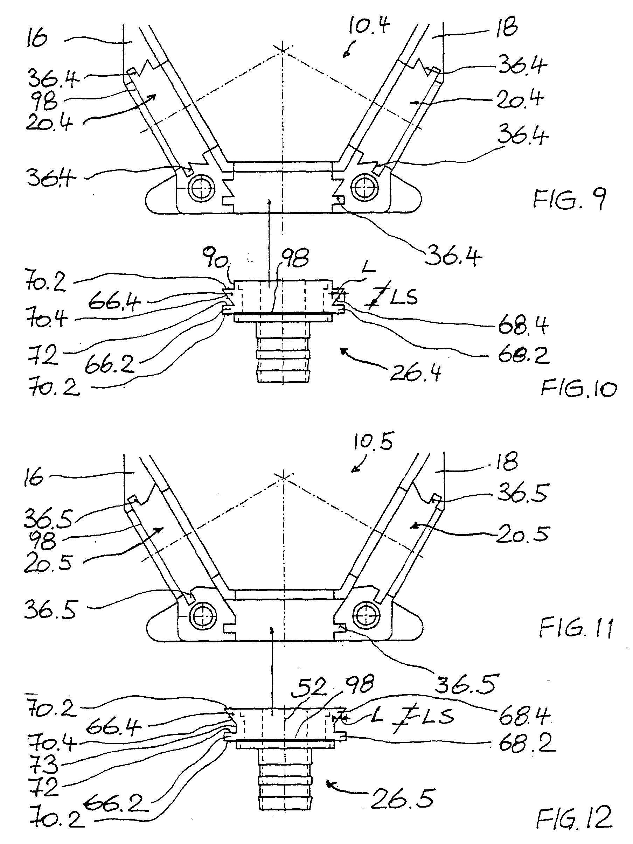

Bei dem Gehäuse 10.4 (Fig. 9, 10) ist eine Verzahnung 36.4 vorhanden, die sich aus einem im Grundriß rechteckförmigen und einem dreieckförmigen Vorsprung 66.2 (68.2) und 66.4 (68.4) zusammensetzt. Die seitlich sich gegenüberstehenden Seitenflächen 70.2 und 72 beim Vorsprung 66.2 sowie 70.2 und 70.4 beim Vorsprung 66.4 sind teilweise rechtwinklig (Seitenfläche 70.2, 72) beziehungsweise schräg (Seitenfläche 70.4) beim Einsatzstück 26.4 oder dem als Blindstopfen 20.4 ausgebildeten Einsatzstück ausgebildet. Die aufsummierte Länge aller auskragenden Seitenflächen der Vorsprünge auf einer Seite des quaderförmigen Körpers beträgt 3 L + LS und ist damit größer als 2 L.

Auch bei der Verzahnung 36.5 (Fig. 11, 12) des Gehäuses 10.5 zwischen dem Einsatzstück 20.5 beziehungsweise 26.5 und der betreffenden Seitenwand 16, 18 dieses Gehäuses ist die aufsummierte Kraglänge genauso groß wie bei der Verzahnung 36.4 gemäß Fig. 9 und 10. Der Unterschied besteht lediglich darin, daß zwischen der schrägen Seitenfläche 70.4 des Vorsprungs 66.4 und der benachbarten, unter 90 Grad zur Längsachse 52 ausgerichteten Seitenfläche 72 des benachbarten Vorsprungs 66.2 eine in Längsrichtung verlaufende Seitenfläche 73 vorhanden ist.

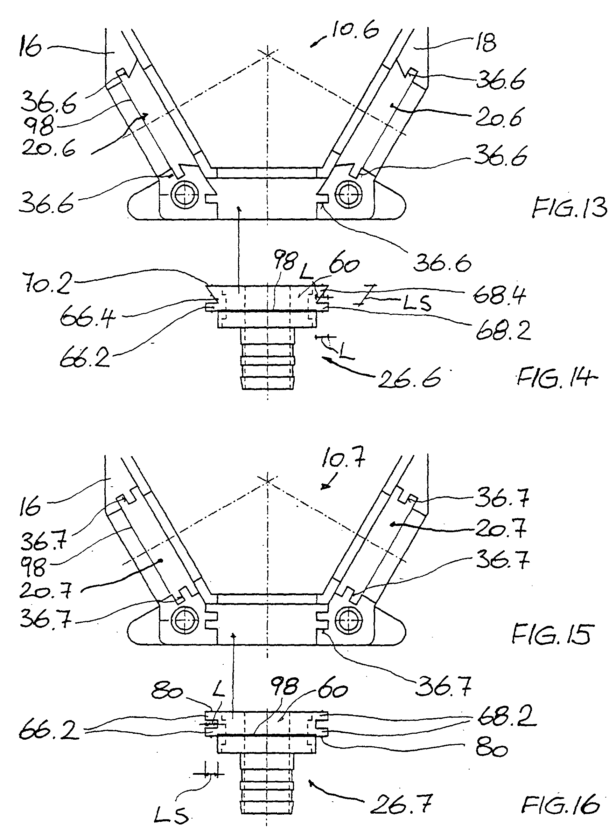

Auch die in Fig. 13, 14 dargestellte Verzahnung 36.6 zwischen einem Einsatzstück 20.6 beziehungsweise 26.6 und der betreffenden Seitenwand 16, 18 eines Gehäuses 10.6 weist -diese vorstehenden auf summierten Kraglängen beziehungsweise Seitenwandlängen von 3 L + LS auf. Im Unterschied zur Verzahnung 36.4 (Fig. 9, 10) liegt der im Querschnitt dreieckförmige Vorsprung 66.4 mit seiner in der Zeichnung oberen Seitenfläche 70.2 bündig zur Außenfläche des quaderförmigen Körpers 60, während dies bei der Verzahnung 36.4 (Fig. 9, 10) nicht der Fall ist. Der dortige Vorsprung 66.4 besitzt einen Rücksprung 90 zu der entsprechenden Außenwand des quaderförmigen Körpers 60.

Die Verzahnung 36.7 beim Gehäuse 10.7 beziehungsweise die in diese Gehäuse einsetzbaren Einsatzstücke 20.7 und 26.7 (Fig. 15, 16) besitzen jeweils zwei Vorsprünge 66.2, 68.2, wie sie auch bei der Verzahnung 36.2 (Fig. 5, 6) vorhanden sind. Der in der Zeichnung obere Vorsprung 66.2 beziehungsweise 68.2 der Verzahnung 36.7 ist bündig mit der Außenwand des quaderförmigen Gehäuses 60, so wie dies ähnlich auch bei der Verzahnung 36.6 (Fig. 13, 14) der Fall ist. Dem gegenüber ist bei der Verzahnung 36.2 gemäß Fig. 5, 6 ein durch eine Seitenwand 62 gebildeter Rücksprung zwischen dem Vorsprung 66.2 und der Außenwand des quaderförmigen Gehäuses 60 vorhanden. Bei der Verzahnung 36.7 ist eine aufsummierte Länge der Vorsprünge wie bei der Verzahnung 36.2 in folgender Weise vorhanden: 4 L = 4 LS.

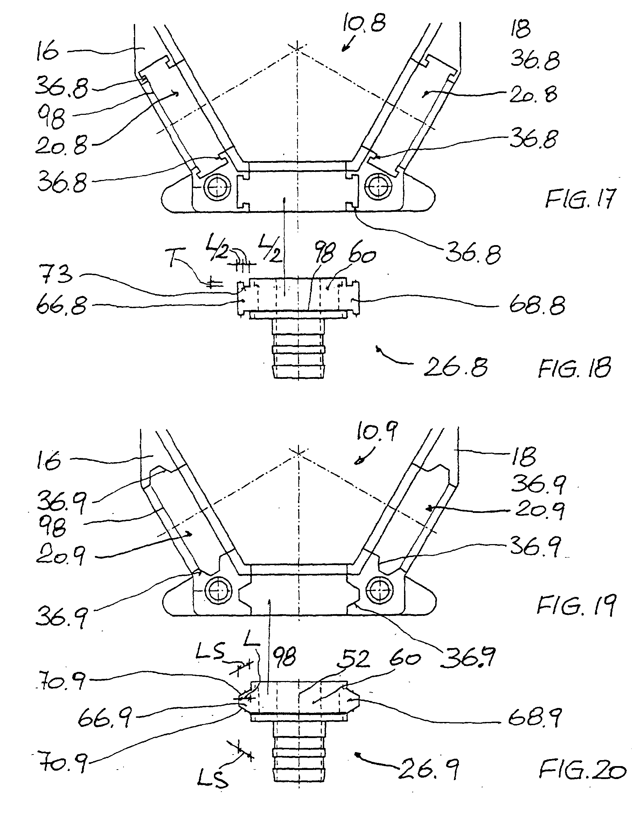

Die in Fig. 17 und 18 dargestellte Verzahnung 36.8 des Gehäuses 10.8 besitzt eine Hammerkopfausbildung an dem betreffenden Einsatzstück 20.8 beziehungsweise 26.8. Der Vorsprung 66.8, 68.8 auf jeder der sich gegenüberliegenden Seiten des quaderförmigen Körpers 60 besitzt eine in der Zeichnung obere und untere jeweils einstufige Seitenflächenausbildung, so daß jeder Vorsprung 66.8, 68.8 eine zweistufige Verzahnung besitzt. Jede Verzahnung wird aus einer stufenförmigen Seitenfläche 73 gebildet, deren durch die Abwinklung auskragende Länge sich zusammensetzt aus L/2 + T + L/2. Beide stufenförmigen Seitenwände 73 besitzen damit aufsummiert eine Gesamtlänge von 2 L + 2 T. Dieses Maß ist größer als 2 L.

Die in Fig. 19, 20 dargestellte Verzahnung 36.9 des Gehäuses 10.9 ist pyramidenstumpfartig ausgebildet. Der einzige Vorsprung 66.9, 68.9 des Einsatzstückes 26.9 besitzt sich gegenüberliegende, schräg zur Längsachse 52 ausgerichtete Seitenflächen 70.9 mit einer jeweiligen Länge LS. Die aufsummierten Längen der auskragenden Seitenflächen eines Vorsprungs besitzen damit das Längenmaß 2 LS. Dieses Maß ist größer als der Wert 2 L. Für die Einsatzstücke 20.9, die in den Seitenwänden 16, 18 als Blindstopfen einsitzen, gilt entsprechendes. Dies gilt im übrigen vergleichsweise für alle vorstehenden Einsatzstücke 20. Die dargestellten Verzahnungen gelten damit in gleicher Weise auch für entsprechende Blindstopfen.

In einem Gehäuse können verschiedenartige Einsatzstücke vorhanden sein. Dies betrifft einmal die Art des Einsatzstückes. So kann das Einsatzstück als Blindstopfen oder als Crimpflansch in dem Gehäuse einsitzen und dementsprechend entweder zum Verschließen einer Seitenwand 16 beziehungsweise 18 oder zum Durchführen eines Kabels verwendet werden. In einem Gehäuse können auch Einsatzstücke mit unterschiedlichen Verzahnungen eingesetzt werden. Dies bedingt dann aber entsprechend unterschiedliche Verzahnungen in der Gehäusewand 16, 18.

Auf den rechtwinklig zu den verzahnten Wänden des quaderförmigen Körpers vorhandenen beiden anderen Außenseiten des Einsatzstückes 26 beziehungsweise 20 ist eine auskragende Querrippe 98 vorhanden. Diese Querrippe 98 ist im vorliegenden Fall nicht nur auf der in den Figuren sichtbaren Außenseite 96, sondern auch auf der dazu gegenüberliegenden Außenseite des quaderförmigen Körpers 60 vorhanden. Diese Querrippen stoßen einerseits auf den Boden 14 vom Bodenteil 12 und andererseits von innen an den in der Zeichnung nicht dargestellten Deckel an, der von oben auf dem Bodenteil 12 und damit auch auf den Einsatzstücken 20 beziehungsweise 26 dicht anliegt. Das Einsatzstück 20, 26 beziehungsweise die vorstehend dargestellten, sich durch die jeweilige Verzahnung unterscheidenden Einsatzstücke haben dadurch nicht nur einen innigen Berührkontakt durch ihren durch die jeweilige Verzahnung und die Längsrippen 80 bewirkten Preßsitz mit den Wänden 16, 18, sondern auch eine spritzwasserdichte Anlage an den übrigen den Einsatzstücken benachbarten Wänden, nämlich dem Boden 14 und dem Deckelteil. Das Gehäuse 10 liegt also umlaufend dicht an den Außenflächen des Einsatzstückes 20 beziehungsweise 26 an.

## Patentansprüche

1. Störstrahlsicheres Gehäuse (10, 10.2, 10.3, 10.4, 10.5, 10.6, 10.7, 10.8, 10.9) zur Aufnahme mindestens eines Steckverbinders und mindestens eines damit verbundenen elektrischen Kabels,
- mit mindestens einer verschließbaren Öffnung, durch die im geöffneten Zustand ein mit dem Steckverbinder zu verbindendes elektrisches Kabel, dessen Längsachse deckungsgleich ist mit der Längsachse (22, 24, 27) der Gehäuseöffnung, in das Gehäuse hinein- beziehungsweise aus dem Gehäuse herausführbar ist,
- mit einem die Öffnung verschließenden Blindstopfen als Einsatzstück (20, 20.2, 20.3, 20.4, 20.5, 20.6, 20.7, 20.8, 20.9) oder einem das elektrische Kabel umschließenden und in die Öffnung einsetzbaren Crimpflansch als Einsatzstück (26, 26.2, 26.3, 26.4, 26.5, 26.6, 26.7, 26.8, 26.9), wobei der Blindstopfen beziehungsweise der Crimpflansch und damit das jeweilige Einsatzstück Vorsprünge (66, 66.2, 66.3, 66.4, 66.8, 66.9, 68, 68.2, 68.3, 68.4, 68.8, 68.9) aufweisen, die mit Rücksprüngen in dem Gehäuse derart korrespondieren, daß das Einsatzstück längs der Rücksprünge, die für ihn Längsführungen darstellen, in das Gehäuse einschiebbar ist,
**dadurch gekennzeichnet, daß**
- eine mehrstufige Verzahnung (36, 36.2, 36.3, 36.4, 36.5, 36.6, 36.7, 36.8, 36.9) zwischen dem Einsatzstück (20, 20.2, 20.3, 20.4, 20.5, 20.6, 20.7, 20.8, 20.9, 26, 26.2, 26.3, 26.4, 26.5, 26.6, 26.7, 26.8, 26.9) und dem Gehäuse (10, 10.2, 10.3, 10.4, 10.5, 10.6, 10.7, 10.8, 10.9) derart vorhanden ist, daß
- die quer zur Längsachse (22, 24, 27) einer Gehäuseöffnung vorhandenen Seitenflächen (70, 70.2, 70.3, 70.4, 72, 72.3) des oder der von einer Seitenwand eines Körpers (60) auskragenden Vorsprünge (66, 66.2, 66.3, 66.4, 66.8, 68, 68.2, 68.3, 68.4, 68.8) eine auskragende Länge besitzen, die aufsummiert mehr als doppelt so groß ist, wie die senkrecht zur Längsachse (22, 24, 27) der Gehäuseöffnung auskragende Länge (L) dieses oder dieser von einer Seitenwand auskragenden Vorsprünge (66, 66.2, 66.3, 66.4, 66.8, 68, 68.2, 68.3, 68.4, 68.8), oder
- der oder die Vorsprünge (66.9, 68.9) eine Hammerkopfausbildung besitzen.

2. Gehäuse nach Anspruch 1,
**dadurch gekennzeichnet, daß**
- zumindest eine Längsrippe (80) und/oder eine Kragwölbung auf der Seitenfläche (70, 72, 73) eines Vorsprunges (66, 68) vorhanden ist.

3. Gehäuse nach Anspruch 1 oder 2,
**dadurch gekennzeichnet, daß**
- zumindest zwei Vorsprünge (66, 68) auf einer Seitenwand (62) des Einsatzstückes (20, 26) vorhanden sind.

4. Gehäuse nach Anspruch 3,
**dadurch gekennzeichnet, daß**
- eine Seitenfläche (70) von einem der mehreren Vorsprünge (66, 68) nicht parallel verläuft zu der gegenüberliegenden Seitenfläche (72) dieses Vorsprunges.

5. Gehäuse nach einem der vorstehenden Ansprüche,
**dadurch gekennzeichnet, daß**
- ein Vorsprung (66.3, 68.3) im Querschnitt schwalbenschwanzförmig oder trapezförmig ausgebildet ist.

6. Gehäuse nach Anspruch 1,
**dadurch gekennzeichnet, daß**
- eine Querrippe (80) auf zumindest einer der nicht Vorsprünge aufweisenden Außenfläche (96) des Einsatzstückes (20, 26) vorhanden ist.

7. Gehäuse nach Anspruch 6,
**dadurch gekennzeichnet, daß**
- die Querrippe (98) sich über die gesamte Außenseite (96) des Körpers (60) erstreckt.

8. Einsatzstück (20, 26) für ein störstrahlsicheres Gehäuse (10, 10.2, 10.3, 10.4, 10.5, 10.6, 10.7, 10.8, 10.9),
- das als ein eine Öffnung in dem Gehäuse (10, 10.2, 10.3, 10.4, 10.5, 10.6, 10.7, 10.8, 10.9) verschließender Blindstopfen (20, 20.2, 20.3, 20.4, 20.5, 20.6, 20.7, 20.8, 20.9) oder als ein in die Öffnung einsetzbarer, eine zentrale Öffnung aufweisender Crimpflansch (26, 26.2, 26.3, 26.4, 26.5, 26.6, 26.7, 26.8, 26.9) ausgebildet ist,
- das einen in etwa quaderförmigen Körper (60) besitzt, von dessen Seitenwänden Vorsprünge (66, 66.2, 66.3, 66.4, 66.8, 66.9, 68, 68.2, 68.3, 68.4, 68.8, 68.9) seitlich auskragen,
- wobei diese Vorsprünge mit Rücksprüngen in dem Gehäuse derart korrespondieren, daß das Einsatzstück (20, 20.2, 20.3, 20.4, 20.5, 20.6, 20.7, 20.8, 20.9, 26, 26.2, 26.3, 26.4, 26.5, 26.6, 26.7, 26.8, 26.9) längs der Rücksprünge, die für ihn Längsführungen darstellen, in das Gehäuse einschiebbar ist,
**dadurch gekennzeichnet, daß**
- durch den oder die von einer Seitenwand eines Körpers (60) auskragenden Vorsprünge (66, 66.2, 66.3, 66.4, 66.8, 66.9, 68, 68.2, 68.3, 68.4, 68.8, 68.9) eine Verzahnung zwischen dem Einsatzstück (20, 20.2, 20.3, 20.4, 20.5, 20.6, 20.7, 20.8, 20.9, 26, 26.2, 26.3, 26.4, 26.5, 26.6, 26.7, 26.8, 26.9) und dem Gehäuse (10, 10.2, 10.3, 10.4, 10.5, 10.6, 10.7, 10.8, 10.9) herstellbar ist, derart, daß
- die quer zur Längsachse (22, 24, 27) einer Gehäuseöffnung vorhandenen Seitenflächen (70, 70.2, 70.3, 70.4, 72, 72.3) des oder der von einer Seitenwand eines Körpers (60) auskragenden Vorsprünge (66, 66.2, 66.3, 66.4, 66.8, 68, 68.2, 68.3, 68.4, 68.8) eine auskragende Länge besitzen, die aufsummiert mehr als doppelt so groß ist, wie die senkrecht zur Längsachse (22, 24, 27) der Gehäuseöffnung auskragende Länge (L) dieses oder dieser von einer Seitenwand auskragenden Vorsprünge (66, 66.2, 66.3, 66.4, 66.8, 68, 68.2, 68.3, 68.4, 68.8), oder
- der oder die Vorsprünge (66.9, 68.9) eine Hammerkopfausbildung besitzen.

9. Einsatzstück nach Anspruch 8,
**dadurch gekennzeichnet, daß**
- zumindest eine Längsrippe (80) und/oder eine Kragwölbung auf der Seitenfläche (70, 72, 73) eines Vorsprunges (66, 68) vorhanden ist.

10. Einsatzstück nach Anspruch 8 oder 9,
**dadurch gekennzeichnet, daß**
- zumindest zwei Vorsprünge (66, 68) auf einer Seitenfläche des Einsatzstückes (20, 26) vorhanden sind.

11. Einsatzstück nach Anspruch 10,
**dadurch gekennzeichnet, daß**
- eine Seitenfläche (70) von einem der mehreren Vorsprünge (66, 68) nicht parallel verläuft zu der gegenüberliegenden Seitenfläche (72) dieses Vorsprunges.

12. Einsatzstück nach einem der Ansprüche 8 bis 11,
**dadurch gekennzeichnet, daß**
- ein Vorsprung (66.3) im Querschnitt schwalbenschwanzförmig oder trapezförmig ausgebildet ist.

13. Einsatzstück nach Anspruch 8,
**dadurch gekennzeichnet, daß**
- eine Querrippe (98) auf zumindest einer der nicht Vorsprünge (66,68) aufweisenden Außenseite (96) des Einsatzstückes vorhanden ist.

14. Einsatzstück nach Anspruch 13,
**dadurch gekennzeichnet, daß**
- die Querrippe (98) sich über die gesamte Außenseite (96) des Körpers (60) erstreckt.

## Claims

1. EMI-proof housing (10, 10.2, 10.3, 10.4, 10.5, 10.6, 10.7, 10.8, 10.9) for accommodating at least one connector and at least one electrical cable connected thereto,
- having at least one opening which can be closed and through which, when it is open, an electrical cable, which is to be connected to the connector and whose longitudinal axis is congruent with the longitudinal axis (22, 24, 27) of the housing opening, can be passed into the housing or out of the housing,
- having a blanking plug, which closes the opening, as an insert (20, 20.2, 20.3, 20.4, 20.5, 20.6, 20.7, 20.8, 20.9) or a crimping flange, which surrounds the electrical cable and can be inserted in the opening, as an insert (26, 26.2, 26.3, 26.4, 26.5, 26.6, 26.7, 26.8, 26.9), the blanking plug or the crimping flange and thus the respective insert having projections (66, 66.2, 66.3, 66.4, 66.8, 66.9, 68, 68.2, 68.3, 68.4, 68.8, 68.9) which correspond to recesses in the housing such that the insert can be pushed into the housing along the recesses which act as longitudinal guides for it, **characterized in that**
- a multi-step toothed section (36, 36.2, 36.3, 36.4, 36.5, 36.6, 36.7, 36.8, 36.9) is provided between the insert (20, 20.2, 20.3, 20.4, 20.5, 20.6, 20.7, 20.8, 20.9, 26, 26.2, 26.3, 26.4, 26.5, 26.6, 26.7, 26.8, 26.9) and the housing (10, 10.2, 10.3, 10.4, 10.5, 10.6, 10.7, 10.8, 10.9) such that
- the side faces (70, 70.2, 70.3, 70.4, 72, 72.3), which are provided transversely with respect to the longitudinal axis (22, 24, 27) of a housing opening, of the projection(s) (66, 66.2, 66.3, 66.4, 66.8, 68, 68.2, 68.3, 68.4, 68.8) protruding from a side wall of a body (60) have a protruding length which is in total more than twice as great as the length (L), which protrudes perpendicularly to the longitudinal axis (22, 24, 27) of the housing opening, of this or these projection(s) (66, 66.2, 66.3, 66.4, 66.8, 68, 68.2, 68.3, 68.4, 68.8) protruding from a side wall, or
- the projection(s) (66.9, 68.9) have a hammer head design.

2. Housing according to Claim 1, **characterized in that**
- at least one longitudinal rib (80) and/or a curved protrusion is provided on the side face (70, 72, 73) of a projection (66, 68).

3. Housing according to Claim 1 or 2, **characterized in that**
- at least two projections (66, 68) are provided on a side wall (62) of the insert (20, 26).

4. Housing according to Claim 3, **characterized in that**
- a side face (70) of one of the plurality of projections (66, 68) does not run parallel to the opposite side face (72) of this projection.

5. Housing according to one of the preceding claims, **characterized in that**
- a projection (66.3, 68.3) is dovetailed or trapezoidal in cross section.

6. Housing according to Claim 1, **characterized in that**
- a transverse rib (80) is provided on at least one of the outer faces (96) of the insert (20, 26) which do not have any projections.

7. Housing according to Claim 6, **characterized in that**
- the transverse rib (98) extends over the entire outer side (96) of the body (60).

8. Insert (20, 26) for an EMI-proof housing (10, 10.2, 10.3, 10.4, 10.5, 10.6, 10.7, 10.8, 10.9),
- which is in the form of a blanking plug (20, 20.2, 20.3, 20.4, 20.5, 20.6, 20.7, 20.8, 20.9) which closes an opening in the housing (10, 10.2, 10.3, 10.4, 10.5, 10.6, 10.7, 10.8, 10.9) or in the form of a crimping flange (26, 26.2, 26.3, 26.4, 26.5, 26.6, 26.7, 26.8, 26.9) which can be inserted in the opening and has a central opening,
- which has an approximately parallelepipedal body (60), from whose side walls projections (66, 66.2, 66.3, 66.4, 66.8, 66.9, 68, 68.2, 68.3, 68.4, 68.8, 68.9) protrude laterally,
- these projections corresponding to recesses in the housing such that the insert (20, 20.2, 20.3, 20.4, 20.5, 20.6, 20.7, 20.8, 20.9, 26, 26.2, 26.3, 26.4, 26.5, 26.6, 26.7, 26.8, 26.9) can be pushed into the housing along the recesses which act as longitudinal guides for it,
**characterized in that**
- a toothed section can be produced between the insert (20, 20.2, 20.3, 20.4, 20.5, 20.6, 20.7, 20.8, 20.9, 26, 26.2, 26.3, 26.4, 26.5, 26.6, 26.7, 26.8, 26.9) and the housing (10, 10.2, 10.3, 10.4, 10.5, 10.6, 10.7, 10.8, 10.9) by the projection(s) (66, 66.2, 66.3, 66.4, 66.8, 66.9, 68, 68.2, 68.3, 68.4, 68.8, 68.9) protruding from a side wall of a body (60) such that
- the side faces (70, 70.2, 70.3, 70.4, 72, 72.3), which are provided transversely with respect to the longitudinal axis (22, 24, 27) of a housing opening, of the projection(s) (66, 66.2, 66.3, 66.4, 66.8, 68, 68.2, 68.3, 68.4, 68.8) protruding from a side wall of a body (60) have a protruding length which is in total more than twice as great as the length (L), which protrudes perpendicularly to the longitudinal axis (22, 24, 27) of the housing opening, of this or these projection(s) (66, 66.2, 66.3, 66.4, 66.8, 68, 68.2, 68.3, 68.4, 68.8) protruding from a side wall, or
- the projection(s) (66.9, 68.9) have a hammer head design.

9. Insert according to Claim 8, **characterized in that**
- at least one longitudinal rib (80) and/or a curved protrusion is provided on the side face (70, 72, 73) of a projection (66, 68).

10. Insert according to Claim 8 or 9, **characterized in that**
- at least two projections (66, 68) are provided on a side face of the insert (20, 26).

11. Insert according to Claim 10, **characterized in that**
- a side face (70) of one of the plurality of projections (66, 68) does not run parallel to the opposite side face (72) of this projection.

12. Insert according to one Claims 8 to 11, **characterized in that**
- a projection (66.3) is dovetailed or trapezoidal in cross section.

13. Insert according to Claim 8, **characterized in that**
- a transverse rib (98) is provided on at least one of the outer sides (96) of the insert which do not have any projections (66, 68).

14. Insert according to Claim 13, **characterized in that**
- the transverse rib (98) extends over the entire outer side (96) of the body (60).

## Revendications

1. Boîtier blindé contre les interférences électromagnétiques (10, 10.2, 10.3, 10.4, 10.5, 10.6, 10.7, 10.8, 10.9) destiné à recevoir au moins un connecteur et au moins un câble électrique raccordé à ce connecteur,
- avec au moins une ouverture obturable à travers laquelle, à l'état ouvert, on peut faire entrer dans le boîtier ou faire sortir du boîtier un câble électrique à raccorder au connecteur, dont l'axe longitudinal coïncide avec l'axe longitudinal (22, 24, 27) de l'ouverture de boîtier,
- avec un bouchon d'obturation obturant l'ouverture comme élément de fermeture (20, 20.2, 20.3, 20.4, 20.5, 20.6, 20.7, 20.8, 20.9) ou une bride de sertissage entourant le câble électrique et insérable dans l'ouverture comme élément de fermeture (26, 26.2, 26.3, 26.4, 26.5, 26.6, 26.7, 26.8, 26.9), le bouchon d'obturation ou la bride de sertissage et donc l'élément de fermeture respectif présentant des saillies (66, 66.2, 66.3, 66.4, 66.8, 66.9, 68, 68.2, 68.3, 68.4, 68.8, 68.9) qui correspondent à des retraits dans le boîtier de telle façon que l'élément de fermeture peut être inséré dans le boîtier le long des retraits qui constituent pour lui des guides longitudinaux,
**caractérisé par le fait**
- **qu'**il existe une imbrication ou un engagement multiple ou pluriel(le) (36, 36.2, 36.3, 36.4, 36.5, 36.6, 36.7, 36.8, 36.9) entre l'élément de fermeture (20, 20.2, 20.3, 20.4, 20.5, 20.6, 20.7, 20.8, 20.9, 26, 26.2, 26.3, 26.4, 26.5, 26.6, 26.7, 26.8, 26.9) et le boîtier (10, 10.2, 10.3, 10.4, 10.5, 10.6, 10.7, 10.8, 10.9) de telle façon que
- les surfaces latérales (70, 70.2, 70.3, 70.4, 72, 72.3) transversales par rapport à l'axe longitudinal (22, 24, 27) d'une ouverture de boîtier de la ou des saillie(s) (66, 66.2, 66.3, 66.4, 66.8, 68, 68.2, 68.3, 68.4, 68.8) dépassant d'une paroi latérale d'un corps (60) possèdent une longueur de dépassement qui, cumulée, est plus que deux fois plus grande que la longueur (L) de cette ou de ces saillie(s) (66, 66.2, 66.3, 66.4, 66.8, 68, 68.2, 68.3, 68.4, 68.8) dépassant d'une paroi latérale perpendiculairement à l'axe longitudinal (22, 24, 27) de l'ouverture de boîtier, ou que
- la ou les saillie(s) (66.9, 68.9) possèdent une forme de tête de marteau.

2. Boîtier selon la revendication 1,
**caractérisé par le fait**
- **qu'**il existe au moins une nervure longitudinale (80) et/ou une courbure en saillie sur la surface latérale (70, 72, 73) d'une saillie (66, 68).

3. Boîtier selon la revendication 1 ou 2,
**caractérisé par le fait**
- **qu'**il existe au moins deux saillies (66, 68) sur une paroi latérale (62) de l'élément de fermeture (20, 26).

4. Boîtier selon la revendication 3,
**caractérisé par le fait**
- **qu'**une surface latérale (70) d'une des plusieurs saillies (66, 68) n'est pas parallèle à la surface latérale opposée (72) de cette saillie.

5. Boîtier selon l'une des revendications précédentes,
**caractérisé par le fait**
- **qu'**une saillie (66.3, 68.3) a une section en queue d'aronde ou trapézoïdale.

6. Boîtier selon la revendication 1,
**caractérisé par le fait**
- **qu'**il existe une nervure transversale (98) sur au moins une des faces extérieures (96) de l'élément de fermeture (20, 26) ne présentant pas de saillies.

7. Boîtier selon la revendication 6,
**caractérisé par le fait**
- **que** la nervure transversale (98) s'étend sur toute la face extérieure (96) du corps (60).

8. Elément de fermeture (20, 26) pour un boîtier blindé contre les interférences électromagnétiques (10, 10.2, 10.3, 10.4, 10.5, 10.6, 10.7, 10.8, 10.9)
- qui est réalisé sous la forme d'un bouchon d'obturation (20, 20.2, 20.3, 20.4, 20.5, 20.6, 20.7, 20.8, 20.9) obturant une ouverture dans le boîtier (10, 10.2, 10.3, 10.4, 10.5, 10.6, 10.7, 10.8, 10.9) ou d'une bride de sertissage (26, 26.2, 26.3, 26.4, 26.5, 26.6, 26.7, 26.8, 26.9) insérable dans l'ouverture, présentant une ouverture centrale,
- qui possède un corps approximativement parallélépipédique (60) des parois latérales duquel dépassent latéralement des saillies (66, 66.2, 66.3, 66.4, 66.8, 66.9, 68, 68.2, 68.3, 68.4, 68.8, 68.9),
- ces saillies correspondant à des retraits dans le boîtier de telle façon que l'élément de fermeture (20, 20.2, 20.3, 20.4, 20.5, 20.6, 20.7, 20.8, 20.9, 26, 26.2, 26.3, 26.4, 26.5, 26.6, 26.7, 26.8, 26.9) peut être inséré dans le boîtier le long des retraits qui constituent pour lui des guides longitudinaux,
**caractérisé par le fait**
- **qu'**une imbrication entre l'élément de fermeture (20, 20.2, 20.3, 20.4, 20.5, 20.6, 20.7, 20.8, 20.9, 26, 26.2, 26.3, 26.4, 26.5, 26.6, 26.7, 26.8, 26.9) et le boîtier (10, 10.2, 10.3, 10.4, 10.5, 10.6, 10.7, 10.8, 10.9) est réalisable par la ou les saillie(s) (66, 66.2, 66.3, 66.4, 66.8, 66.9, 68, 68.2, 68.3, 68.4, 68.8, 68.9) dépassant une paroi latérale d'un corps (60) de telle façon que
- les surfaces latérales (70, 70.2, 70.3, 70.4, 72, 72.3) transversales par rapport à l'axe longitudinal (22, 24, 27) d'une ouverture de boîtier de la ou des saillie(s) (66, 66.2, 66.3, 66.4, 66.8, 68, 68.2, 68.3, 68.4, 68.8) dépassant une paroi latérale d'un corps (60) possèdent une longueur de dépassement qui, cumulée, est plus que deux fois plus grande que la longueur (L) de cette ou de ces saillie(s) (66, 66.2, 66.3, 66.4, 66.8, 68, 68.2, 68.3, 68.4, 68.8) dépassant une paroi latérale perpendiculairement à l'axe longitudinal (22, 24, 27) de l'ouverture de boîtier, ou que
- la ou les saillie(s) (66.9, 68.9) possèdent une forme de tête de marteau.

9. Elément de fermeture selon la revendication 8,
**caractérisé par le fait**
- **qu'**il existe au moins une nervure longitudinale (80) et/ou une courbure en saillie sur la surface latérale (70, 72, 73) d'une saillie (66, 68).

10. Elément de fermeture selon la revendication 8 ou 9,
**caractérisé par le fait**
- **qu'**il existe au moins deux saillies (66, 68) sur une paroi latérale de l'élément de fermeture (20, 26).

11. Elément de fermeture selon la revendication 10,
**caractérisé par le fait**
- **qu'**une surface latérale (70) d'une des plusieurs saillies (66, 68) n'est pas parallèle à la surface latérale opposée (72) de cette saillie.

12. Elément de fermeture selon l'une des revendications 8 à 11,
**caractérisé par le fait**
- **qu'**une saillie (66.3) a une section en queue d'aronde ou trapézoïdale.

13. Elément de fermeture selon la revendication 8,
**caractérisé par le fait**
- **qu'**il existe une nervure transversale (98) sur au moins une des faces extérieures (96) de l'élément de fermeture (20, 26) ne présentant pas de saillies (66, 68).

14. Elément de fermeture selon la revendication 13,
**caractérisé par le fait**
- **que** la nervure transversale (98) s'étend sur toute la face extérieure (96) du corps (60).
